# EUROPEAN PATENT APPLICATION

(11) **EP 3 073 636 A2**
(43) Date of publication of application: **28.09.2016**
(21) Application number: 15165204.7
(22) Date of filing: 27.04.2015
(51) Int. Cl.: H02S 40/36, H02S 20/23, H01L 31/05, H01L 31/02, H01L 31/048, H02S 30/20

(54) **SOLAR PANEL MODULE AND METHOD FOR FABRICATING THE SAME**

(30) Priority: 23.03.2015 TW 104109142
(71) Applicant: Hulk Energy Technology Co., Ltd., 35154 Miaoli County (TW)
(72) Inventor: HUANG, Ting-Hui, 35154 Miaoli County (TW); CHOU, Chen-Nan, 35154 Miaoli County (TW)
(74) Representative: Straus, Alexander

(57) **Abstract**

A solar panel module (1000, 1100) is provided having a plurality of solar panels (100, 100') disposed in juxtaposed relation. Each of the solar panels (100, 100') has a positive ribbon (121b, 121b') at one side of said solar panel (100, 100') and a negative ribbon (111a, 111a') at the other side opposite to said one side. Two adjacent ribbons of two adjacent solar panels (100, 100') are both positive ribbons (121b, 121b') or both negative ribbons (111a, 111a').

## Description

### FIELD OF THE INVENTION

The present invention relates to a solar panel module and a method for fabricating such a solar panel module.

### BACKGROUND OF THE INVENTION

Solar cells have been studied and developed recently. The industry always has great interests in promoting the power conversion efficiency of photoelectrical layers and solar power density of solar panel modules. Therefore, an improved high-efficiency solar panel module is needed.

### SUMMARY OF THE INVENTION

One object of the present invention is to provide a method for fabricating a high-efficiency solar panel module comprising the following steps. A plurality of solar panels is provided. A positive ribbon is formed at one side of a front surface of said each solar panel and a negative ribbon is formed at the other side opposite to said one side of the front surface of said each solar panel. The positive ribbon and the negative ribbon are folded back to a back surface of said each solar panel to become a backside positive ribbon and a backside negative ribbon respectively. The plurality of solar panels are sandwiched between a back sheet and a cover panel and laminated with the back sheet and the cover panel. The two adjacent ribbons of two adjacent solar panels are both positive ribbons or both negative ribbons.

Another object of the present invention is to provide a high-efficiency solar panel module comprising a plurality of solar panels disposed in juxtaposed relation. Each solar panel of the plurality of solar panels has a positive ribbon at one side of said each solar panel and a negative ribbon at the other side opposite to said one side. Two adjacent ribbons of two adjacent solar panels are either both positive ribbons or both negative ribbons.

Another object of the present invention is to provide a solar panel module comprising a cover panel, a back sheet, at least one solar panel, a first encapsulant. a second encapsulant and a first water-resistant sealant. The first encapsulant is disposed between the back sheet and the at least one solar panel. The second encapsulant is disposed between the cover panel and the at least one solar panel. The first water-resistant sealant is disposed between the cover panel and the back sheet in a periphery region projecting from the plurality of solar panels. The first water-resistant sealant is in physical contact with a sidewall of the at least one solar panel.

### BRIEF DESCRIPTION OF THE DRAWINGS

Figs. 1-5 show a method for fabricating a solar panel module according to the first embodiment of the present invention.
Fig. 6 shows a solar panel module according to another embodiment of the present invention.
Fig. 7 shows a schematic cross-sectional view of a solar panel module according to an embodiment of the present invention.
Fig. 8 shows a schematic enlarged cross-sectional view detailing encapsulants and sealant used in a solar panel module according to an embodiment of the present invention.

### DETAILED DESCRIPTION OF THE INVENTION

The following descriptions illustrate preferred embodiments of the present invention in detail. All the components, sub-portions, structures, materials and arrangements therein can be arbitrarily combined in any sequence despite their belonging to different embodiments and having different sequence originally. All these combinations are falling into the scope of the present invention.

There are a lot of embodiments and figures within this application. To avoid confusions, similar components are designated by the same or similar numbers. To simplify figures, repetitive components are only marked once.

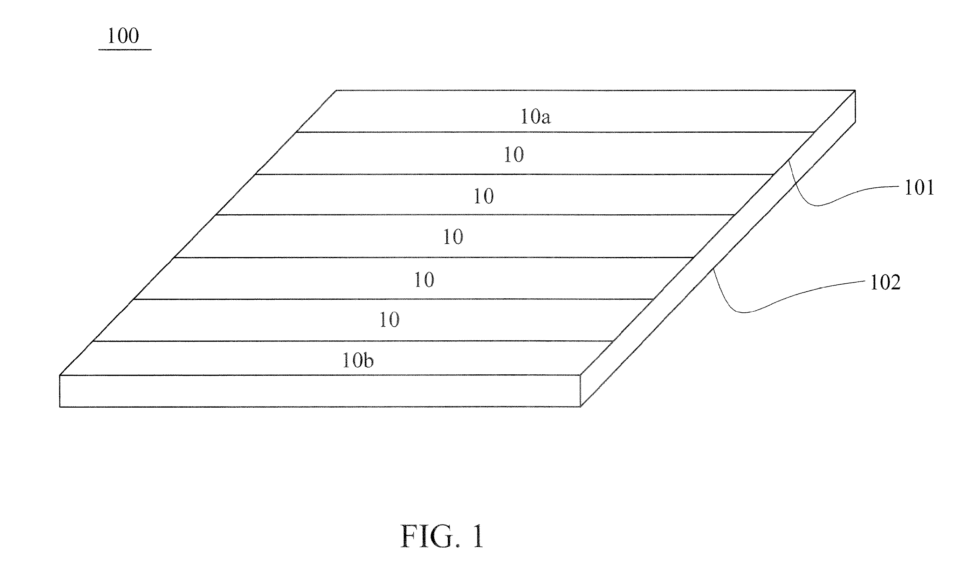

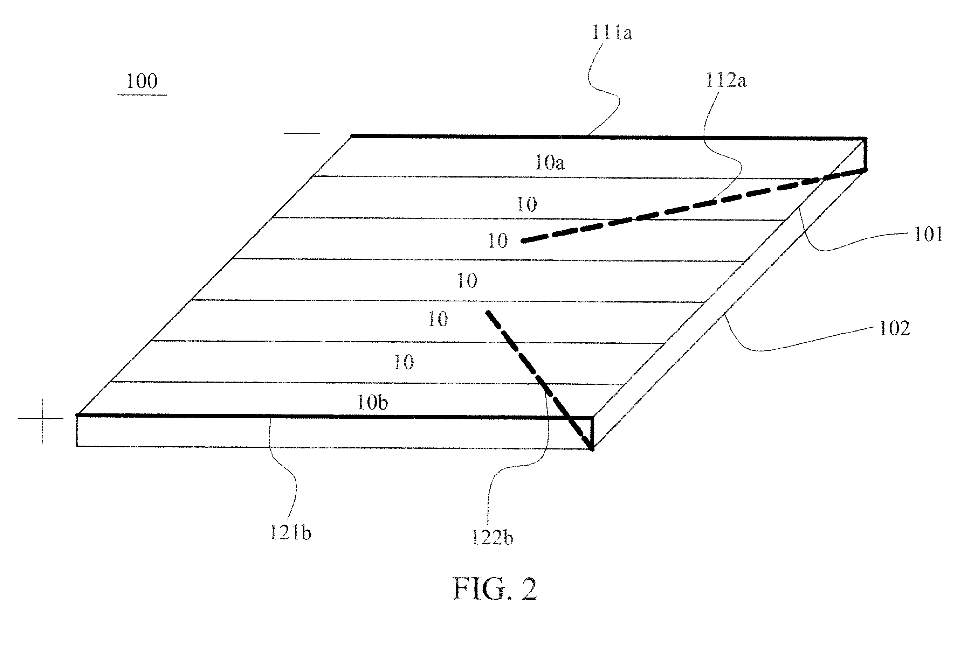

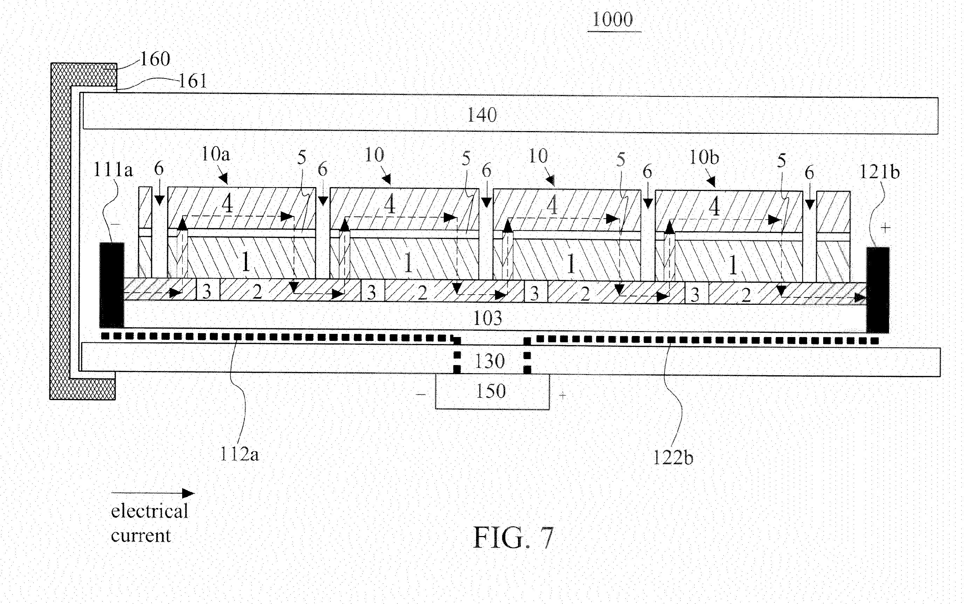

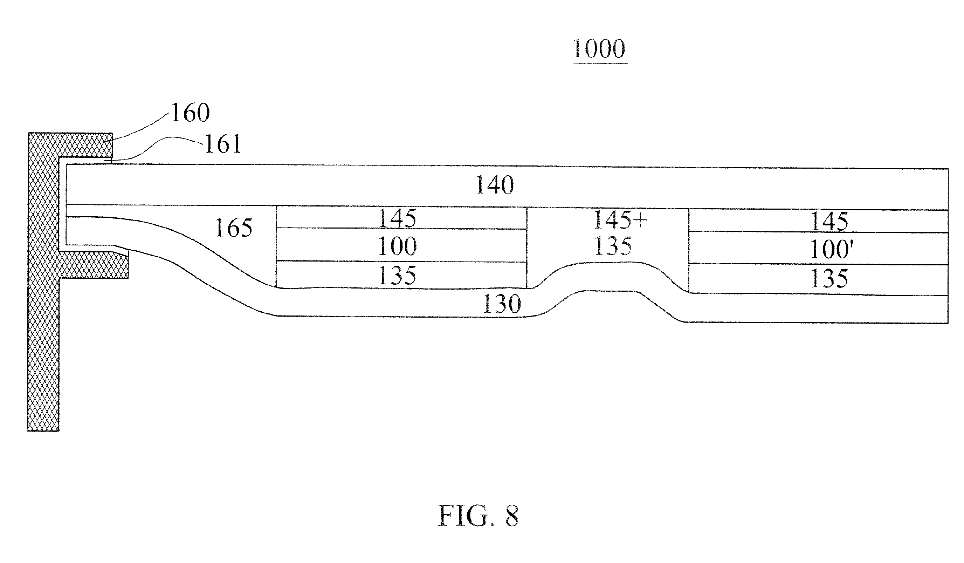

Please refer to Figs. 1-5 and 7-8 now. Figures 1-5 show a method for fabricating a solar panel module according to the first embodiment of the present invention. Fig. 7 shows a schematic cross-sectional view of a solar panel module according to an embodiment of the present invention. Fig. 8 shows a schematic enlarged cross-sectional view detailing encapsulants and sealant used in a solar panel module according to an embodiment of the present invention. First, prepare a plurality of solar panels 100 as shown in Fig. 1. Each solar panel 100 comprises a front surface 101 and a back surface 102 and comprises a plurality of solar cell units 10a, 10b and 10 electrically connected in serial. Solar cell units 10a and 10b represent solar cell units at two ends of the solar panel 100 while solar cell unit 10 represents one of the solar cell units between the solar cell units 10a and 10b. Then, please refer to Fig. 2. The solar panel 100 preferably has a rectangle shape with two long sides and two short sides. Dispose a front side positive ribbon 121b and a front side negative ribbon 111a at two long sides opposite to each other of the front surface 101 of the solar panel 100 and fold the front side positive ribbon 121b and the front side negative ribbon 111a back to the back surface 102 of solar panel 100 to become a backside positive ribbon 122b and a backside negative ribbon 112a respectively. In most of the figures of the present invention, the backside positive ribbon 122b and the backside negative ribbon 112a are shown by dashed lines to be different from the front side positive ribbon 121b and the front side negative ribbon 111a shown by solid lines. The front side positive ribbon 121b and the front side negative ribbon 111a are used as a positive electrode and a negative electrode of the solar panel respectively. The ribbons for example can be made from copper foil, copper ribbon, foils of other metals or alloy or ribbons of other metals or alloys.

As shown by Fig. 7, each solar panel 100 has a stacked structure from bottom to top comprising a back glass 103, a patterned lower electrode layer 2, a patterned photoelectric conversion layer 1, an optional patterned buffer layer 5 and a patterned transparent upper electrode layer 4. Fig. 7 focuses on the detailed structure of the solar panel 100 and the relative relations between the solar panel 100 and a back sheet 130 and a cover panel 140, so adhesives such as encapsulants and sealants are omitted in Fig. 7. Such adhesives are shown in Fig. 8. The patterned lower electrode layer 2 and the patterned transparent upper electrode layer 4 are configured to conduct electrical current generated by the patterned photoelectric conversion layer 1. The patterned photoelectric conversion layer 1 is configured to receive light penetrating the patterned transparent upper electrode layer 4 and the optional patterned buffer layer 5 and convert the light into electricity. The photoelectric conversion layer may be formed from a semiconductor material composed of copper (Cu), indium (In), gallium (Ga) and selenium (Se). Alternatively, the photoelectric conversion layer may be formed from a semiconductor compound material comprising Ib group element such as copper (Cu) or silver (Ag), IIIb group element such as aluminum (Al), gallium (Ga) or indium (In) and VIb group element such as sulfur (S), selenium (Se) or tellurium (Te). The transparent upper electrode layer may use indium tin oxide (ITO) and/or zinc oxide (ZnO). The lower electrode layer may use molybdenum (Mo).

The back glass 103 is an unpatterned bulk dielectric structure. The patterned lower electrode layer 2 is formed on the back glass 103. There are separation gaps 3 disposed between different patterns of the lower electrode layer 2 and separation gaps 3 may be filled with resin or other dielectric materials to electrically isolate different patterns of the lower electrode layer 2. The patterned photoelectric conversion layer 1 and the optional patterned buffer 5 are formed on the patterned lower electrode layer 2. A pattern of the lower electrode layer 2 may be used to electrically connect two solar cell units in serial such as solar cell units 10 and 10 or solar cell units 10 and 10a or solar cell units 10 and 10b. A pattern of the lower electrode layer 2 may also be used to electrically connect a solar cell unit 10a (or 10b) and a electrode ribbon 111a (or 121b). In one solar cell unit 10 (or 10a or 10b), there is a gap (not numbered) between two adjacent patterns of the photoelectric conversion layer 1 and between two adjacent patterns of the optional buffer layer 5 and such a gap is filled with the upper transparent electrode layer 4 so the upper transparent electrode layer 4 can be electrically connected to the lower electrode 2 (physically connected in this case). Between two solar cell units 10 and 10 or between two solar cell units 10 and 10a or between two solar cell units 10 and 10b there is a separation gap 6. Such a separation gap 6 would be filled with resin or other dielectric materials in a subsequent process. In each solar cell unit 10 (or 10a or 10b), when light penetrates the upper transparent electrode layer 4 and the optional buffer layer 5 and reaches the photoelectric conversion layer 1, a potential of electricity would be generated in the photoelectric conversion layer 1 and results in an electrical current flowing for example from the upper transparent electrode layer 4 to the lower electrode layer 2 (shown as the dashed line arrow in Fig. 7). In the solar panel 100, the electrical current would flow from the front side negative ribbon 111a through a pattern of the lower electrode layer 2, a pattern of the transparent upper electrode layer 4, a pattern of the photoelectric conversion layer 1, another pattern of the lower electrode layer 2, another pattern of the transparent upper electrode layer 4, another pattern of the photoelectric conversion layer 1.....to the front side positive ribbon 121b. The direction of an electrical current is opposite to the direction of a flow of an electron. It should be noted that the drawings of this invention are not drawn to scale. Furthermore, in a real cross-sectional view taken along a cutting line one can not see the front side positive ribbon 121b and the front side negative ribbon 111a in connection with the backside positive ribbon 122b and the backside negative ribbon 112a, but Fig. 7 is drawn to show all of them in order to illustrate the connection relation of the ribbons.

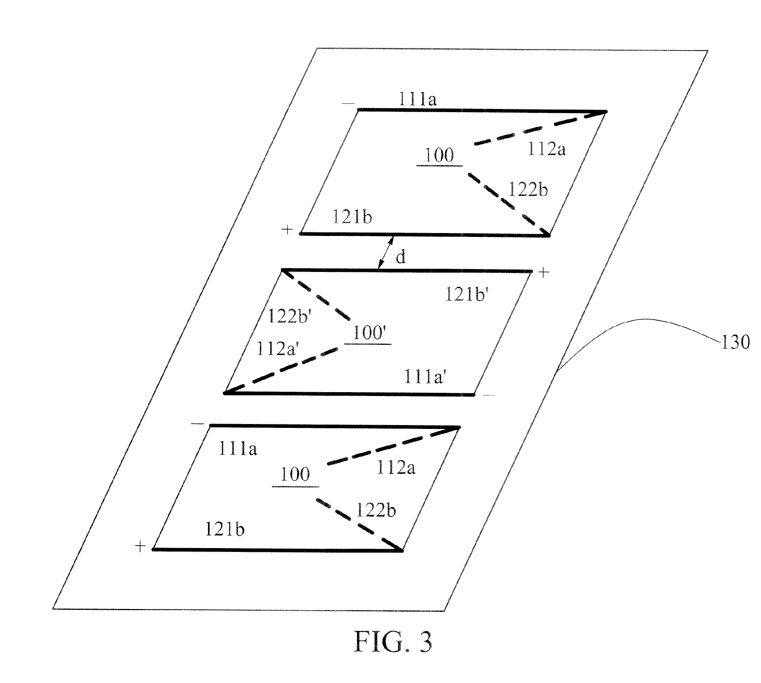

Then, please refer to Figs. 3 and 8. Dispose the plurality of solar panels 100 (100') in juxtaposed relation on a back sheet 130. The back sheet 130 is the back sheet shown in Fig. 8 and may be a rigid back sheet or a flexible back sheet. The size of the back sheet 130 is so chosen that its length should extend beyond the solar panels 100 (100') at two ends and its width is larger than the width of one solar panel 100(100'). Flexible back sheet may be a high-tensile plastic sheet such as polyethylene (PE) sheet, polyamide (PA) sheet, polyethylene terephthalate (PET) sheet or a combination thereof. Rigid back sheet may be a tempered glass, a chemically strengthened glass or a polymeric resin sheet. The back sheet may also be a combination of a material from above and a metallic foil attached thereto. There are only three solar panels shown in Fig. 3 for illustration, but the present invention may be applied to a case of more solar panels. In a preferred embodiment, more than three solar panels 100 (100') are disposed in juxtaposed relation on a back sheet 130. The solar panel 100' is the same as the solar panel 100 in view of their structures but has different orientation, so the details of the solar panel 100' is omitted here. According to a method for fabricating a solar panel module of the present invention, when disposing the plurality of solar panels 100 (100') one should make sure that two adjacent electrodes of two adjacent solar panels 100 and 100' are electrodes of the same electrical polarity. That is, the positive electrode of a solar panel 100 is adjacent to the positive electrode of an adjacent solar panel 100' at one side while the negative electrode of the solar panel 100 is adjacent to the negative electrode of another adjacent solar panel 100' at another side opposite to said one side. Two adjacent electrodes of opposite polarities too close to each other may result in electrical leakage problems. In the present invention, adjacent electrodes of two adjacent solar panels 100 and 100' have the same polarity (both positive or both negative), so the shortest distance d between the adjacent electrodes of two adjacent solar panels 100 and 100' may be 2 mm or less. Preferably, the shortest distance d between the adjacent electrodes of two adjacent solar panels 100 and 100' may be not more than 5 mm and not less than 1 mm. As such, the solar panel module of the present invention can dispose more solar panel within a fixed area, thereby providing higher power per unit area. After disposing the plurality of solar panels 100 (100') on the back sheet 130 in place and confirming their special relationship, dispose a first encapsulant 135 between the plurality of solar panels 100 (100') and the back sheet 130 as shown in Fig. 8. The back sheet 130 has a plurality of openings (not shown) and each solar panel 100 (100') corresponds to at least one opening in a central region (or other region) of said each solar panel 100 (100'). The backside positive ribbon 122b (122b') and the backside negative ribbon 112a (112a') of each solar panel 100 (100') extend through the first encapsulant 135 and at least one of plurality of openings (not shown) and electrically connect outward (to other solar panels and to a connection box 150 which will be discussed later). The first encapsulant 135 for example is a thermal encapsulant such as ethylene Vinyl Acetate (EVA), polyolefin (PO) and polyvinyl butyral (PVB), or an UV curable encapsulant, or a combination thereof.

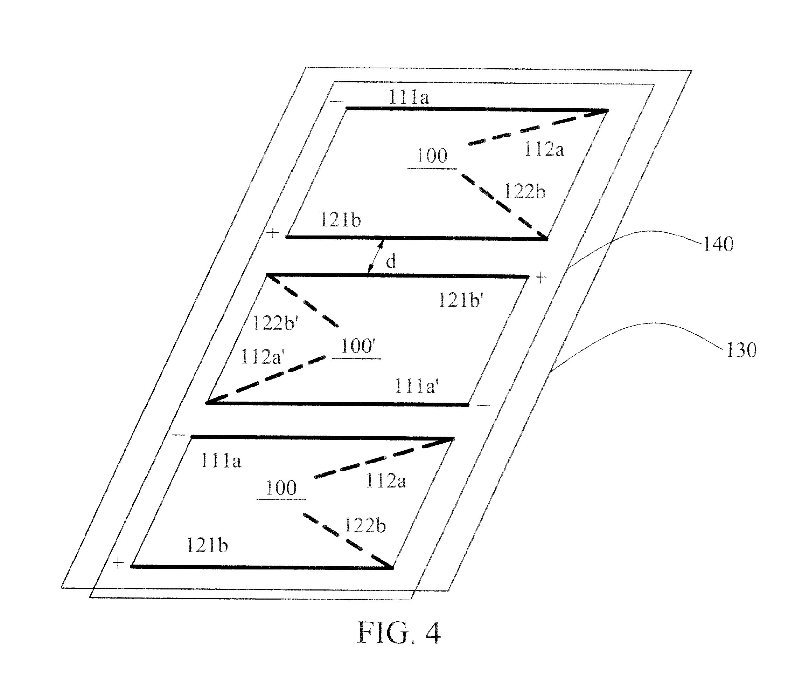

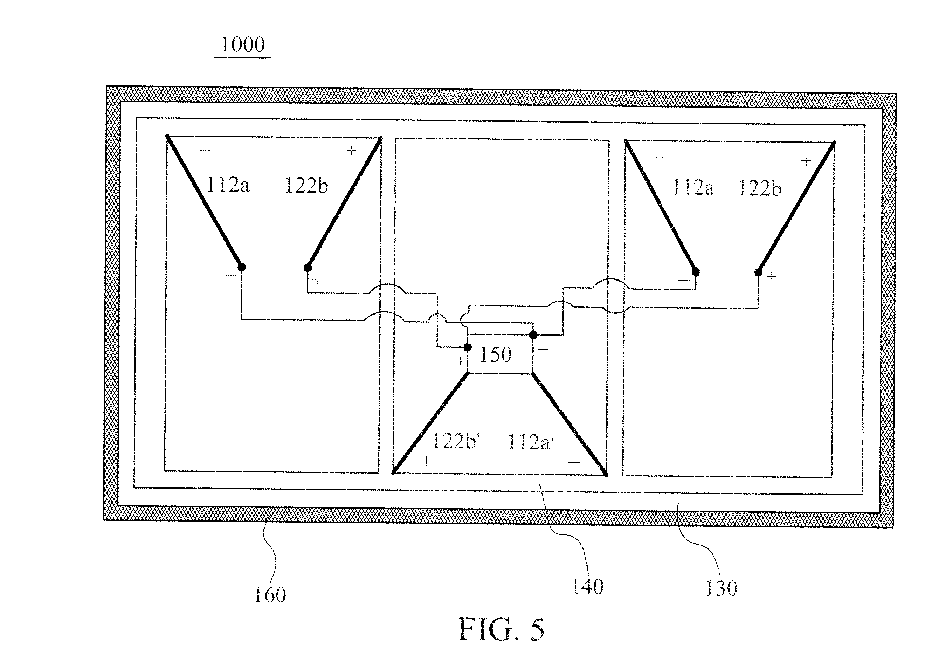

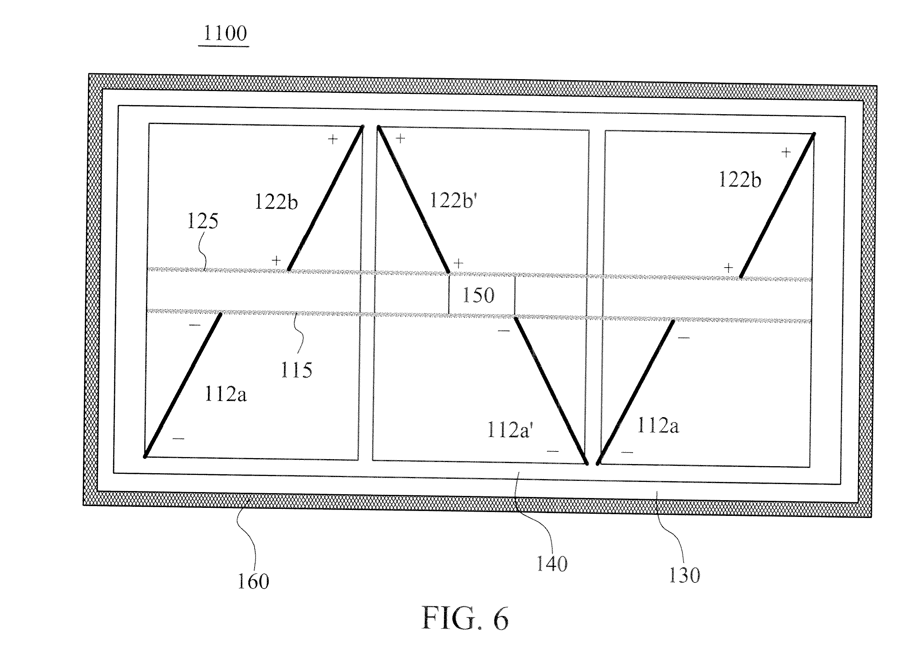

Then, please refer to Figs. 4 and 8. Dispose a cover panel 140 on the plurality of solar panels 100 (100') and dispose a second encapsulant 145 between the plurality of solar panels 100 (100') and the cover panel 140 as shown in Fig. 8. The cover panel 140 for example is a rigid glass panel and the size of the cover panel 140 is preferably equivalent to or smaller than the size of the back sheet 130. The material used for the second encapsulant 145 is similar to the material used for the first encapsulant 135 and the materials for the second encapsulant 145 and the first encapsulant 135 may be the same or different. Next, the cover panel 140, the second encapsulant 145, the plurality of solar panels 100 (100'), the first encapsulant 135 and the back sheet 130 are laminated together by at least one vacuum laminating process. Since the back sheet 140 and the cover panel 130 are so sized that the lengths thereof both extend beyond solar panels 100 (100') at two ends of the plurality of solar panels and the widths thereof are both larger than a length of one solar panel 100 (100'), a first water-resistant sealant 165 can be disposed between the cover panel 130 and the back sheet 140 in a periphery region projecting from the plurality of solar panels and optionally in multiple gap regions between adjacent solar panels 100 and 100'. The periphery region may have a shape similar to the shape of a frame 160 shown in Figs. 5 and 6 which will be discussed later. The first water-resistant sealant 165 is for example thermalplastic polyolefin (TPO) or butyl rubber and is in physical contact with at least one sidewall of each solar panel 100 (100') of the plurality of the plurality of solar panels 100 (100') to protect the plurality of solar panels 100 (100') from moisture and mechanical force. That is, all the sidewalls of the plurality of solar panels 100 (100') are surrounded by either encapsulant (the first encapsulant 135 and the second encapsulant 145) or sealant (the first water-resistant sealant 165), so the photoelectric conversion layers 1 of the plurality of solar panels 100 (100') would not degrade due to moisture or mechanical force.

Then, please refer to Figs. 5, 7 and 8. Install a connection box 150 in a back surface of the back sheet as shown in Fig. 5. The connection box 150 can be disposed in a central region of the back sheet 130 (corresponding to the middle solar panel) as shown in Fig. 5 or disposed in the end of the back sheet 130 (corresponding to a solar panel at the end) as shown in Fig. 7. Alternatively, the connection box 150 can be disposed in any region of the back sheet 130. As shown in Fig. 7, the backside positive ribbon 122b (122b') extending through at least one opening (not shown) of the back sheet 130 should be connected to the anode of the connection box 150 while the backside negative ribbon 112a (112a') extending through at least one opening (not shown) of the back sheet 130 should be connected to the cathode of the connection box 150. Furthermore, using the backside positive and negative ribbons or additional conductive lines to electrically connect all the plurality of solar panels 100 (100') in parallel. At last, install a frame 160 at fringes of the cover panel 140 and the back sheet 130 based on the sizes of the cover panel 140 and the back sheet 130 (in Fig. 5 the size of cover panel 140 is smaller than the size of the back sheet 130 while in Fig. 7 the size of the cover panel 140 is equivalent to the size of the back sheet 130) and dispose a water-resistant third encapsulant 161 between the frame 160 and the cover panel 140 and between the frame 160 and the back sheet 130 as shown in Figs. 7 and 8. The solar panel module 1000 of the present invention can be fabricated according to the steps described above. The third encapsulant 161 is for example acrylic tape. The connection box 150 may further comprise a positive conductive line and a negative conductive line connecting outward (not shown) in order to electrically connect the solar panel module 1000 to an external device. An additional water-resistant resin layer such as a polyolefin layer may be optionally disposed on a back surface of the back sheet 130 in order to protect the connection box 150 and the back sheet 130 from moisture and mechanical force.

It is noted that each figure focuses on different element or relation between elements, so all the elements are not drawn in scale. For example, Fig. 8 focuses on the distribution of the first encapsulant 135, the second encapsulant 145 and the first water-resistant sealant 165 in a case where a flexible back sheet 130 is used, so the solar panels 100 and 100' are relatively small compared to their actual sizes while the encapsulants, sealant, gaps between solar panels and distances between the back sheet and the cover panel are exaggerated. Due to the sucking effect occurred during the vacuum laminating process, the flexible back sheet 130 would be closer to the cover panel 140 in an area without solar panels such as the periphery area surrounding the plurality of solar panels 100 (100') and the gap region between adjacent solar panels 100 and 100'. However, the back sheet 130 could be a rigid back sheet (not shown in Fig. 8) and the distance between the back sheet 130 and the cover panel 140 would be approximately the same throughout the whole solar panel module.

Now please refer to Fig. 6. Fig. 6 shows a solar panel module 1100 according to another embodiment of the present invention. The solar panel module 1100 is similar to the solar panel module 1000 in view of their structures. The differences between the solar panel modules 1100 and 1000 are the arrangement of the backside positive ribbon 122b (122b') and the backside negative ribbon 112a (112a') and the positive and negative conductive lines on the back surface of the back sheet 130. In the solar panel module 1000, the backside positive ribbon 122b (122b') and the backside negative ribbon 112a (112a') of a solar panel 100 (100') are both folded from the same short side of said solar panel 100 (100') and extend therefrom. In the solar panel module 1100, the backside positive ribbon 122b (122b') and the backside negative ribbon 112a (112a') of a solar panel 100 (100') are folded from different short sides of said solar panel 100 (100') and extend therefrom; the different short sides are opposite to each other. Moreover, in the solar panel module 1100, there are positive conductive lines 125 and negative conductive lines 115 spanning all the solar panels 100 (100') within the solar panel module 1100. The positive conductive line 125 is connected to the anode of the connection box 150 and all the backside positive ribbon 122b (122b') of all the solar panels 100 (100') while the negative conductive line 115 is connected to the cathode of the connection box 150 and all the backside negative ribbon 112a (112a').

The embodiments of Figs. 1-5 dispose the solar panel 100 and the solar panel 100' alternatively but the concept of disposing adjacent electrodes with the same polarity of the present invention can be applied to cases where all the solar panels have the same orientation. Furthermore, the embodiments of Figs. 1-6 have a plurality of solar panels electrically connected in parallel but the concept of disposing adjacent electrodes with the same polarity of the present invention can be applied to cases where a plurality of solar panels are electrically connected in serial. In the present invention, adjacent electrodes of two adjacent solar panels have the same polarity (both positive or both negative), so the shortest distance between the adjacent electrodes of two adjacent solar panels may be 2 mm or less. As such, the solar panel module of the present invention can dispose more solar panel within a fixed area, thereby providing higher power per unit area. The detailed structure of solar panels shown in Fig. 7 and the distribution of encapsulants and sealant shown in Fig. 8 can be applied to the embodiment of Figs. 1-5 and the embodiment of Figs. 1-6. Moreover, the distribution of encapsulants and sealant shown in Fig. 8 can also be applied to a case where a solar panel module comprises only one solar panel.

While the invention has been described in terms of what is presently considered to be the most practical and preferred embodiments, it is to be understood that the invention needs not be limited to the disclosed embodiment. On the contrary, it is intended to cover various modifications and similar arrangements included within the spirit and scope of the appended claims which are to be accorded with the broadest interpretation so as to encompass all such modifications and similar structures.

## Claims

1. A solar panel module (1000, 1100), comprising:
a plurality of solar panels (100, 100') disposed in juxtaposed relation, each solar panel of the plurality of solar panels (100, 100') having a positive ribbon (121b, 121b') at one side of said each solar panel (100, 100') and a negative ribbon (111a, 111a') at the other side opposite to said one side,
wherein two adjacent ribbons of two adjacent solar panels (100, 100') are either both positive ribbons (121b, 121b') or both negative ribbons (111a, 111a').

2. The solar panel module according to claim 1, wherein said each solar panel (100, 100') comprises a back glass (103) and a patterned photoelectric conversion layer (1) disposed on the back glass.

3. The solar panel module according to claim 1 or 2, wherein the positive ribbon (121b, 121b') and the negative ribbon (111a, 111a') of said each solar panel (100, 100') are disposed on a front surface (101) of said each solar panel (100, 100') and folded back to a back surface (102) of said each solar panel (100, 100') to become a backside positive ribbon (122b, 122b') and a backside negative ribbon (112a, 112a') respectively.

4. The solar panel module according to any of claims 1-3, further comprising:
a cover panel (140), disposed above the plurality of solar panels (100, 100'); and
a back sheet (130), disposed under the plurality of solar panels (100, 100'),
wherein the cover panel (140), the plurality of solar panels (100, 100') and the back sheet (130) are laminated.

5. The solar panel module according to claim 4, further comprising:
a first encapsulant (135), disposed between the plurality of solar panels (100, 100') and the back sheet (130); and
a second encapsulant (145), disposed between the plurality of solar panels (100, 100') and the cover panel (140),
wherein the first or the second encapsulant (135, 145) is ethylene vinyl acetate (EVA), polyolefin (PO), polyvinyl butyral (PVB), UV curable encapsulant, or a combination thereof.

6. The solar panel module according to claim 4 or 5, wherein the back sheet (130) and the cover panel (140) are so sized that the lengths thereof both extend beyond end solar panels of the plurality of solar panels (100, 100') and the widths thereof are both larger than a length of said each solar panel (100, 100'), the solar panel module (1000, 1100) further comprising:
a first water-resistant sealant (165), disposed between the cover panel (140) and the back sheet (130) in a periphery region projecting from the plurality of solar panels (100, 100'), wherein the first water-resistant sealant (165) is in physical contact with sidewalls of the plurality of solar panels (100, 100').

7. The solar panel module according to any of claims 1-6, wherein a shortest distance (d) between the two adjacent ribbons ((121b, 121 b') or (111a, 111a')) of the two adjacent solar panels (100, 100') is not more than 5 mm.

8. The solar panel module according to any of claims 1-6, wherein a shortest distance (d) between the two adjacent ribbons ((121b, 121b') or (111a, 111a')) of the two adjacent solar panels (100. 100') is not less than 1 mm.

9. A method for fabricating a solar panel module (1000, 1100), comprising:
providing a plurality of solar panels (100, 100');
forming a positive ribbon (121b, 121b') at one side of a front surface (101) of said each solar panel (100, 100') and a negative ribbon (111a, 111a') at the other side opposite to said one side of the front surface (101) and folding back the positive ribbon (121b, 121b') and the negative ribbon (111a, 111a') back to a back surface (102) of said each solar panel (100, 100') to become a backside positive ribbon (122b, 122b') and a backside negative ribbon (112a, 112a') respectively;
sandwiching the plurality of solar panels (100, 100') between a back sheet (130) and a cover panel (140) and laminating the plurality of solar panels (100, 100'), the back sheet (130) and the cover panel (140) together,
wherein two adjacent ribbons of two adjacent solar panels (100, 100') are both positive ribbons (121b, 121b') or both negative ribbons (111a, 111a').

10. The method for fabricating a solar panel module according to claim 9, the back sheet (130) has a plurality of openings, the method further comprising:
disposing a connection box (150) corresponding to the plurality of solar panels (100, 100') so that the positive ribbon (121b, 121b') and the negative ribbon (111a, 111a') of said each solar panel (100, 100') extend through at least one of plurality of openings and electrically connect to the connection box (150).

11. The method for fabricating a solar panel module according to claim 9 or 10, comprising:
disposing a first encapsulant (135) between the plurality of solar panels (100, 100') and the back sheet (130); and
disposing a second encapsulant (145) between the plurality of solar panels (100, 100') and the cover panel (140),
wherein the first or the second encapsulant (135, 145) is ethylene vinyl acetate (EVA), polyolefin (PO), polyvinyl butyral (PVB), UV curable encapsulant, or a combination thereof.

12. The method for fabricating a solar panel module according to any of claims 9-11, wherein a shortest distance (d) between the two adjacent ribbons ((121b, 121b') or (111a, 111a')) of two adjacent solar panels (100, 100') is not more than 5 mm.

13. The method for fabricating a solar panel module according to any of claims 9-11, wherein a shortest distance (d) between the two adjacent ribbons ((121b, 121b') or (111a, 111a')) of two adjacent solar panels (100, 100') is not less than 1 mm.

14. The method for fabricating a solar panel module according to any of claims 9-13, further comprising:
disposing a first water-resistant sealant (165) between the cover panel (140) and the back sheet (130) in a periphery region projecting from the plurality of solar panels (100, 100'), the first water-resistant sealant (165) is in physical contact with sidewalls of the plurality of solar panels (100, 100').

15. The method for fabricating a solar panel module according claim 14, further comprising:
providing a frame (160) at fringes of the cover panel (140) and the back sheet (130) and disposing a third encapsulant (161) between the frame (160) and the cover panel (140), between the frame (160) and the back sheet (130) and between the frame (160) and the first water-resistant sealant (165).

16. A solar panel module (1000, 1100), comprising:
a cover panel (140);
a back sheet (130);
at least one solar panel (100, 100'), between the cover panel (140) and the back sheet (130), wherein the cover panel (130) and the back sheet (140) project from the at least one solar panel (100, 100');
a first encapsulant (135), disposed between the back sheet (130) and the at least one solar panel (100, 100');
a second encapsulant (145), disposed between the cover panel (140) and the at least one solar panel (100, 100'); and
a first water-resistant sealant (165), between the cover panel (140) and the back sheet (130) in a periphery region projecting from the plurality of solar panels (100, 100'), the first water-resistant sealant (165) is in physical contact with a sidewall of the at least one solar panel (100, 100').

17. The solar panel module according to claim 16, further comprising:
a frame (160), disposed at fringes of the back sheet (130) and the cover panel (140); and
a third encapsulant (161), disposed between the frame (160) and the cover panel (140), between the frame (160) and the back sheet (130) and between the frame (160) and the first water-resistant sealant (165).

18. The solar panel module according to claim 16 or 17, wherein the first encapsulant or the second encapsulant (135, 145) is ethylene vinyl acetate (EVA), polyolefin (PO), polyvinyl butyral (PVB), UV curable encapsulant, or a combination thereof.

19. The solar panel module according to any of claims 16-18, wherein the first water-resistant sealant (165) is thermalplastic polyolefin (TPO) or butyl rubber.

20. The solar panel module according to any of claims 17-19, wherein the third encapsulant (161) is acrylic tape.
